# EUROPEAN PATENT APPLICATION

(11) **EP 3 444 375 A1**
(43) Date of publication of application: **20.02.2019**
(21) Application number: 17186126.3
(22) Date of filing: 14.08.2017
(51) Int. Cl.: C23C 16/26, C23C 16/02, C23C 16/46, C23C 16/448, C01B 32/186, H01M 4/583

(54) **METHOD FOR FORMATION OF A GRAPHENE LAYER**

(71) Applicant: INL - International Iberian Nanotechnology Laboratory, 4715-330 Braga (PT); University Of Minho, 4800-058 Guimaraes (PT)
(72) Inventor: Gilles Ollivier Borme, Jerome, 4710-409 Braga (PT); Luis Machado Junior, Jorge, 4715-559 Braga (PT); Pedro dos Santos Hall de Agorreta de Alpium, Joao, 4715-010 Braga (PT); Barbosa Queiros, Raquel, 4475-327 Milheiros, Maia (PT); Jorge Peixeiro de Freitas, Paulo, 2730-287 Barcarena, Oeiras (PT)
(74) Representative: AWA Sweden AB

(57) **Abstract**

The present invention relates to a method for formation of a graphene layer (110) on a metal layer (104, 306) arranged in a process chamber of a chemical vapour deposition, CVD, tool. The method (200) comprising: heating (204) the process chamber to a temperature in the range of 800 °C to 900 °C thereby heating the metal layer (104, 306), introducing (206) a carbon-including deposition-gas into the process chamber thereby forming carbon-including precursors, transporting (208) the carbon-including precursors to the metal layer (104, 306) thereby forming the graphene layer (110) on the metal layer (104, 306).

## Description

### Technical Field

The present invention relates to a method for formation of a graphene layer on a metal layer arranged in a process chamber of a chemical vapour deposition, CVD, tool.

### Background Art

Graphene may be construed as a one-atom-thick layer of carbon atoms arranged in a hexagonal lattice. In graphene, each carbon atom in the lattice is covalently bonded to three others, leaving one of the valence electrons free to move. As a result, the electric conduction in graphene is high compared to for instance silicon. The electronic mobility of graphene may be in the order of 15 000 cm²·V⁻¹·s⁻¹, to be compared with silicon which exhibits an electronic mobility of about 1 400 cm²·V⁻¹·s⁻¹ at room temperature. However, the quality of the graphene and the substrate on which the graphene is arranged may limit the electron transport.

Graphene is also about 100 times stronger than the strongest steel when only one atom thick, conducts heat and electricity efficiently. Graphene is therefore envisioned to revolutionize markets and to allow for improved processes, better performing components and new products, for instance as stronger material structures or faster device components.

To this end, carbon materials such as glassy carbon have long been used as electrodes for electrochemical sensing. The recent discovery of graphene and graphene-related materials has, however, brought about the possibility of using graphene in electrochemistry, in particular as a coating on top of other electrodes to provide improved electrical transport along the metals of the electrodes. Electrochemical electrodes coated with graphite-related materials further provide larger electrochemical currents as compared to other forms of carbon coated electrodes, effectively increasing the signal and therefore the sensitivity of the electrodes. Adsorption/desorption of gases to and from the graphene efficiently changes the electrical properties of graphene making graphene suitable as a sensing material. The large surface area of graphene also enhances the surface loading of biomolecules, and the conductivity and relatively small band gap is further beneficial for conducting electrons between biomolecules and the electrode surface. Thus, graphene is considered a suitable material when providing electrodes and sensors.

The formation of graphene is, however, complicated and time demanding. Graphene may, moreover, be formed in layers which may be single layer, bilayer or multilayer. Fabrication techniques include, for example, mechanical exfoliation of graphite to produce graphene nanopellets and graphite nanopellets; chemical vapour deposition (CVD) which uses the catalytic decomposition of hydrocarbons, typically on top of a metal surface, to produce graphene layers; or chemical oxidation of graphite using strong oxidizing chemicals such as potassium permanganate, followed by an exfoliation by sonication in solution. The latter technique produces graphene oxide nanopellets, which are often submitted to a reduction process, by either applying a chemical treatment, an electrochemical process, a thermal annealing, or by an exposure to ultraviolet radiation to produces nanopellets of reduced graphene oxide.

There are further several means of attaching graphite-related materials to a substrate such as a metal surface. Graphite-related materials may, for example, be electrochemically attached to the electrodes. Screen-printed and inkjet-printed electrochemical electrodes may also be used where a graphite-related material is prepared in an aqueous solution and applied selectively into a desired shape by using a printing technique such as screen printing or inkjet printing. CVD, mentioned above, and transfer of graphene layers may further be used to produce continuous graphene layers on a metal surface. The graphene layers may then be transferred to other substrates, using one of the known transfer processes such as the roll to roll transfer bubble delamination or copper dissolution.

The techniques above using nanopellets as raw material are suffering from a distribution in average pellet size and the nanopellets are deposited at random on the surface and partially overlap leading to a distribution of monolayer, bilayer, and multiple-layer carbon material, where each type has distinct properties.

In the case of the materials are in their oxidized form, there is an increased problem of the use of large amounts of dangerous acids and oxidants, tightening the conditions of production. Also, the quality of the resulting material depends on the raw graphite, which will vary depending on the chemical process employed by different providers to mine and purify graphite from coal.

Thus, there is a need for more efficient methods for providing graphene layers and in particular for providing a graphene layer on a metal layer.

### Summary of the Invention

An object of the present invention is therefore to provide an improved method for forming a graphene layer on a metal layer.

According to one aspect of the present invention a method for formation of a graphene layer on a metal layer arranged in a process chamber of a chemical vapour deposition, CVD, tool is provided. The method comprising: heating the process chamber to a temperature in the range of 800 °C to 900 °C thereby heating the metal layer, introducing a carbon-including deposition-gas into the process chamber thereby forming carbon-including precursors, transporting the carbon-including precursors to the metal layer thereby forming the graphene layer on the metal layer.

The temperature range 800 °C to 900 °C improves the quality of the graphene layer produced. The relatively low heating temperatures, compared to prior art, reduce the residual stress in the metal layer. There is therefore, for example, no need of a strain relaxing layer between the metal layer and a substrate. A thinner graphene metal sandwich may thereby be formed. The temperature range 800 °C to 900 °C further reduces problems associated with the metal layer melting during the heating. The number of metals that may be used for forming the metal layer may further be increased.

An improved uniformity pf the graphene layer may further be obtained in comparison to prior art techniques such as graphene wet transfer.

The method further increases the reproducibility in forming uniform graphene layers on a metal.

The method further provides a graphene layer having a lower impedance. The lower impedance allows for improved sensitivity for instance when using the graphene layer for sensing applications.

The wording *forming carbon-including precursors* may be construed as comprising a physical separation of elements of the carbon-including deposition-gas such that carbon-including precursors are provided. The skilled person is knowledgeable of that different techniques may be used to form the carbon-including precursors. In case of a carbon-including deposition-gas, comprising hydrocarbons, high-temperature decomposition may be used to provide the carbon-including precursors which may also be referred to as carbon deposits or reagents.

The wording *transporting the carbon-including precursors,* may be construed as a physically transportation the carbon-including precursors by means of, for example, gas flows such that they reach, i.e. impinge, on the metal layer. The carbon-including precursors may reach the metal layer by different transport mechanisms. The transport of carbon-including precursors may be directed to the metal layer by, for example, flowing gas towards the metal layer. The transport may alternatively or in combination be passive in that the carbon-including precursors may reach the metal layer by random trajectories within the process chamber. The transport may, for example, be a result of gas diffusion within the process chamber. The wording *carbon-including precursor* may be construed as a carbon containing compound that participates in a chemical reaction to produces graphene.

The metal layer may comprise a metal chosen from the group consisting of: Cu, Ni, Co, Mo, Ru, Pd, Ir, Pt, Au, Ag, Fe, and stainless steel.

These materials and/or their alloys may be used as catalysts for the graphene formation. An improved formation of uniform graphene layers over larger areas is thereby achieved.

The metal layer may consist of a metal chosen from the group consisting of: Cu, Ni, Co, Mo, Ru, Pd, Ir, Pt, Au, Ag, Fe and stainless steel. A pure metal layer may thereby be provided. The skilled person realises that a metal layer should be understood to substantially consist of the above elements. The metal layer may, however, further comprise defects and/or impurities.

The metal layer may form a substrate. Improved handling of the metal layer is thereby provided.

The metal layer may be arranged on a substrate. The substrate and the metal layer may comprise of or be formed by different materials. The substrate may, for example, be a semiconductor such as silicon.

The metal layer may be arranged on an adhesion layer arranged on the substrate. The adhesion layer improves the sticking of the metal layer on the substrate.

The substrate may be provided with an insulating layer and wherein the metal layer is formed on the insulating layer. The insulating layer may thereby provide electrical insulation mitigating problems which may be associated with the substrate being doped and hence conducting.

The substrate may be provided with an insulating layer and wherein the adhesion layer is formed on the insulating layer. A better sticking of the metal layer to the substrate is thereby achieved.

The pressure in the process chamber during the formation of the graphene layer may lie within a range of 0.2 mbar to 1.5 mbar.

At these pressures mass transport is typically reduced or absent and the graphene layer formation is primarily controlled by the temperature of the gases present in the process chamber and the substrate; by the adsorption of the carbon-including precursors in the metal surface; and desorption of remaining fragments of the decomposition.

The carbon-including deposition-gas may consist of a gas chosen from the group consisting of: methane, ethene and ethyne.

The method further comprises: introducing an additional gas into the process chamber. The additional gas may act as a carrier of the carbon-including deposition-gas. The amount of carbon-including deposition-gas may further be reduced. To this end, pressure in the process chamber discussed above is favourable compared to atmospheric pressure since if the additional gas is increased to atmospheric pressure, the pressure of the carbon-including deposition-gas needs to be lowered into regimes where its accurate regulation is more difficult.

The addition of the additional gas may be used to influence the properties of the graphene growth, e.g. to control of the crystalline size and crystalline fraction of the graphene material or to facilitate biofunctionalization.

The additional gas may comprise a gas chosen from the group consisting of: H₂, Ar, NH₃, and N₂.

The method may further comprise: a first cooling step, wherein the process chamber is cooled to a temperature in the range of 350 °C to 400 °C thereby cooling the graphene layer.

The process chamber may be evacuated to a pressure below 10⁻⁵ mbar prior to or during the first cooling step.

The method may further comprise: a second cooling step wherein a coolant gas is introduced into the process chamber and the process chamber is cooled to a temperature in the range of 50 °C - 150 °C thereby cooling the graphene layer.

The pressure in the process chamber may be about 0.2 mbar to 1.0 mbar during the second cooling step. A further scope of applicability of the present invention will become apparent from the detailed description given below. However, it should be understood that the detailed description and specific examples, while indicating preferred embodiments of the invention, are given by way of illustration only, since various changes and modifications within the scope of the invention will become apparent to those skilled in the art from this detailed description.

Hence, it is to be understood that this invention is not limited to the particular component parts of the device described or steps of the methods described as such device and method may vary. It is also to be understood that the terminology used herein is for purpose of describing particular embodiments only, and is not intended to be limiting. It must be noted that, as used in the specification and the appended claim, the articles "a," "an," "the," and "said" are intended to mean that there are one or more of the elements unless the context clearly dictates otherwise. Thus, for example, reference to "a unit" or "the unit" may include several devices, and the like. Furthermore, the words "comprising", "including", "containing" and similar wordings do not exclude other elements or steps.

### Brief description of the drawings

The above and other aspects of the present invention will now be described in more detail, with reference to appended drawings showing embodiments of the invention. The figures should not be considered limiting the invention to the specific embodiment; instead they are used for explaining and understanding the invention.

As illustrated in the figures, the sizes of layers and regions are exaggerated for illustrative purposes and, thus, are provided to illustrate the general structures of embodiments of the present invention. Like reference numerals refer to like elements throughout.
Figure 1 a schematically illustrates a material structure comprising a metal layer.
Figure 1b schematically illustrates the material structure after the formation of a graphene layer on the metal layer.
Figure 2 illustrates a method for formation of a graphene layer on a metal layer.
Figure 3 schematically illustrates another material structure after the formation of a graphene layer on the metal layer.
Figure 4 illustrates a Raman spectrum obtained on a graphene layer produced by the method for formation of a graphene layer on a metal layer.
Figure 5 illustrates electrochemical impedance spectroscopy measurements.

### Detailed description

The present invention will now be described more fully hereinafter with reference to the accompanying drawings, in which currently preferred embodiments of the invention are shown. This invention may, however, be embodied in many different forms and should not be construed as limited to the embodiments set forth herein. These embodiments are rather provided for thoroughness and completeness, and for fully conveying the scope of the invention to the skilled person.

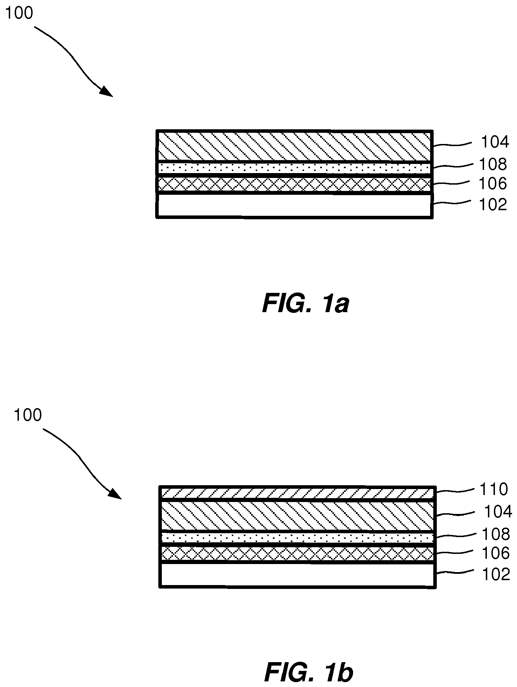

Figure 1 a illustrates a material structure 100 comprising a substrate 102 and a metal layer 104. The material structure 100 may be seen as a pre-stage or base structure on which the graphene layer is to be formed on the metal layer 104. The substrate 102 may be a semiconductor material such as silicon. The semiconductor material may be doped. The substrate 102 is here exemplified as a doped silicon wafer.

An insulating layer 106 may be formed on the substrate 102 to reduce or prevent electrical potentials pertaining to the doped substrate 102 to influence the metal layer. The insulating layer 106 may be a thermal oxide layer or comprise or be formed by an insulating layers deposited at on the substrate 102. The insulating layer 106 may comprise or consist of silicon oxide or silicon nitride. The thickness of the insulating layer 106 may be in the thickness range of typically 100 nm to 1000 nm to provide an adequate electrical insulation shielding the electrical properties of the doped substrate. The insulating material may, for example, be a silicon nitride layer of about 300 nm.

The substrate may be formed by other substantially flat and/or polished substrates that are used in the semiconductor industry, in particular transparent substrates such as fused silica, quartz, sapphire, magnesium oxide, silicon carbide, or opaque substrates made of ceramics, which can be heated to the required temperatures.

The substrate may, for example, be an intrinsic silicon wafer.

The substrate may be undoped. The metal layer may be formed directly on the undoped substrate.

The substrate may be electrically insulating. This is advantageous when the formed graphene layer is to be applied in the field of sensors, where electrical voltages may be applied to the graphene-covered metal catalyst. For such a system a conductive substrate would introduce a short-circuit between different parts of the sensor lowering the performance of the sensor.

The material structure 100 may further comprise an adhesion layer 108. As the substrate 102, is provided with the insulating layer 106, the adhesion layer 108 is here provided on the insulating layer 106, i.e. in-between the metal layer 104 and the insulating layer 106. The adhesion layer 108 may improve the sticking or adhesion of the metal layer 104 on the insulating layer 106. A more durable material structure 100 may thereby be provided. A purer metal layer 104 and subsequently a purer graphene layer may further be provided.

The adhesion layer 108 may, for example, be tantalum or titanium-tungsten alloy or its nitride derivative, chromium or iron. This thickness of the adhesion layer 108 may, for example, be in the range of 3 nm to 20 nm. The adhesion layer 108 may be produced by a number of deposition methods such as sputtering or evaporation, preferably by DC sputtering in vacuum or evaporation in vacuum. The adhesion layer may comprise a refractory metal, i.e. a metal that is resistant to heat and mechanical wear. Suitable refractory metals have melting points above 2000 °C, are chemically inert and have a relatively high density. An adhesion layer comprising a refractory metal therefore mitigates problems associated with metal diffusion into the metal layer. A purer metal layer and graphene layer may thereby be provided. The adhesion layer may, for example, be 3 nm of tantalum. The adhesion layer may alternatively comprise a refractory metal such as Nb, Mo, W, Re or metals such as Cr, Ti, or Zr or other metals having melting points above 1850 °C which may be referred to as refractory metals in a wider definition.

The metal layer 104 may also be provided by deposition techniques such as sputtering or evaporation known to the skilled person. The skilled person in the art is also aware of that the more uniform the metal layer is the smoother may the graphene be made.

The deposition of the metal layer 104 is preferably performed in vacuum. The deposition of the metal layer 104 is preferably also performed after the deposition of the adhesion layer 108 without breaking the vacuum created for the deposition of the adhesion layer 108. The thickness of the metal layer may be in the range of 100 nm to 10 µm, preferably between 200 nm and 2 µm, more preferably 1 µm.

The skilled person realizes that different metal catalysts may have different metal thicknesses which are optimal for forming the graphene layer.

The metal layer may alternatively be formed on an insulating layer.

The metal layer may alternatively be formed directly on the substrate.

The metal layer may be formed by Cu.

The number of graphene layers formed may be determined by the formation time. Growth on a Cu metal layer further reduces problems associated with the solubility of carbon in for example nickel or ruthenium.

To this end, Ni metal layers are also known to produce a multi-layer graphene where the number of graphene layers formed layers also depends on the cooling conditions, requiring additional controls on the cooling speed to obtain the desired result.

Next, a method for formation of a graphene layer on the metal layer arranged in a process chamber of a chemical vapour deposition, CVD, tool will be described. The material structure 100 may for this purpose be arranged in a process chamber of a chemical vapour deposition, CVD, tool, not shown. It may be noted that, the tool CVD may be construed as a tool or process machine suitable to form a thin solid layer with a thickness ranging from a single atomic layer to the micrometer scale on a substrate by use of a chemical reaction of vapour-phase precursors impinging on the substrate. CVD processes have many advantages as they offer: good step coverage, dense films, high deposition rates, scalability to larger areas and reduced costs. The skilled person realizes that detailed processes in CVD are complex and involve a series of gas-phase and surface reactions, which will not be described in detail. It is, however, noted that the CVD process described here may be described as comprising the steps of: evaporation of carbon-including deposition-gas in the process chamber thereby, by separation of elements of the carbon-including deposition-gas, forming carbon-including precursors; transport, i.e. move and direct the carbon-including precursors, by means of, for example, gas flows and/or ballistic injection of carbon-including precursors into the process chamber such that they reach the metal layer; gas phase reactions of the carbon-including precursors near the surface of the metal layer, i.e. in a so-called reaction zone, to produce carbon-including reactive intermediates and gaseous by-products; mass transport of carbon-including precursors to the metal layer surface; adsorption of the carbon-including precursors on the metal layer surface; and surface diffusion to growth sites, nucleation and surface chemical reactions leading to the graphene layer formation on the metal layer; and desorption and mass transport of remaining fragments of the decomposition away from the reaction zone.

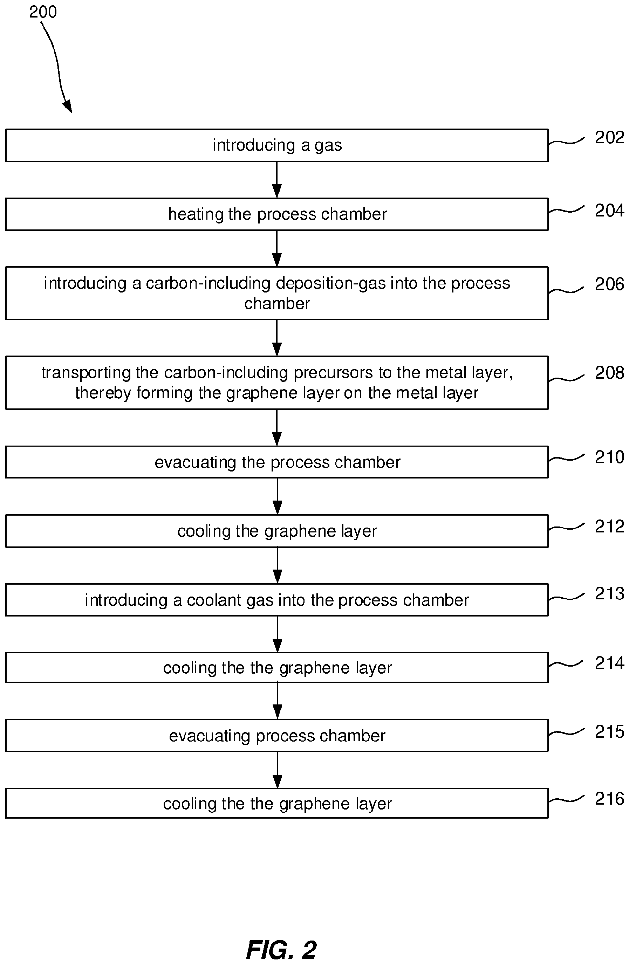

The method 200 for formation of a graphene layer 110 on the metal layer 104 arranged on the material structure 100 is described in more detail with reference to figures 1b and 2. The method 200 may comprise introducing 202, see figure 2, a carrier gas into a process chamber of the CVD tool. The carrier gas is in the following exemplified to be H₂, but may comprise or be formed by other inert gases such as He, or Ar. The gas pressure in the process chamber may, for example, be set to be 0.6 mbar, but other gas pressures may be used as is known to the skilled person.

The whole material structure 100 or at least the metal layer 104 may be heated by heating 204 the process chamber to a temperature in the range of 800 °C to 900 °C. A selected temperature within this range may be referred to as a target temperature. The heating 204 of the process chamber to reach the target temperature may be achieved over a time period in the range of minutes, in the range of 10 - 30 minutes. The process chamber may further be maintained at the target temperature for an additional time period to provide a uniform target temperature throughout the process chamber. The additional time period may, for example, be 30 minutes. The carrier gas may assist in providing a more uniform temperature in the process chamber. A carbon-including deposition-gas is then introduced 206 into the process chamber thereby forming carbon-including precursors.

It is to be understood that the carbon-including deposition-gas decomposes into atomic carbon and hydrogen when entering in contact with the heated metal layer. It is therefore a thermal process that happens at the surface. The atomic carbon may be understood to be a graphene precursor. More specifically the atomic carbon may have a sufficient in-plane mobility to move until it reaches a graphene nucleation centre, where it adds up to the graphene structure laterally.

The carbon-including deposition-gas may comprise or consist of a gas chosen from the group consisting of: methane, ethene and ethyne. The method may further comprise introducing, not shown, an additional gas into the process chamber.

The additional gas may comprise a gas chosen from the group consisting of: H₂, Ar, NH₃, and N₂.

The additional gas may act as a carrier of the carbon-including deposition-gas.

An additional gas comprising N₂ and NH₃ may be used to dope a graphene layer with nitrogen atoms and/or enable certain graphene bio-functionalisation routes.

The carbon-including deposition-gas and the additional gas may be introduced simultaneously. The carbon-including deposition-gas and the additional gas may be mixed prior to the introduction into the process chamber of the CVD tool. The carbon-including deposition-gas and the additional gas may be at a ratio of 1:1. As an example the carbon-including deposition-gas and the additional gas may consist of CH₄:H₂ at a ratio of 1:1.

The pressure in the process chamber during the formation of the graphene layer 110 may lie within a range of 0.2 mbar to 1.5 mbar.

The pressure in the process chamber may be varied during the formation of the graphene layer 110. As an example the pressure in the process chamber may in a first step be 0.4 mbar for a first time period of 4 minutes, and in a second step be 1.1 mbar for a second time period of 10 minutes.
The pressure in the process chamber may alternatively be fixed during the formation of the graphene layer 110. As example, a pressure of 1.1 mbar may be maintained for a time period of 10 minutes during the formation of the graphene layer.

The method further comprises transporting 208 the carbon-including precursors to the metal layer 104 thereby forming the graphene layer 110 on the metal layer 104, see figure 1b illustrating the material structure 100 after the formation of the graphene layer 110. The graphene layer 110 is formed in contact with and on top of the metal layer 104. The graphene of the graphene layer 110 is thereby selectively grown on metal layer 104.

The skilled person realizes that underlying reasons for the selective growth is complicated; It may be argued that there is a striking similarity between the surface structure of crystal plane (111) of several metals, e.g. Cu, Co, Ru, Ir and graphene, and it has been suggested that the fact that the carbon ring, made of 6 carbon atoms, that is the basis of graphene can surround almost perfectly the said metal atoms in the (111) plane is a factor that promotes the favourable binding of carbon atoms at the surface. However, it has further been disclosed that the (111) plane is not a requirement and growth proceeds similarly on metal crystal planes showing other symmetries.

A further advantage of the method 200 is that the used temperature range 800 °C to 900 °C mitigates problems associated with evaporation of the metal layer. A thinner metal layer may therefore be used. As an example, the metal layer may consist of Cu having a thickness of 1000 nm. The metal layer may, however, comprise or consist of a metal chosen from the group consisting of: Ni, Co, Mo, Ru, Pd, Ir, Pt, Au, Ag, Fe and stainless steel. It may further be noted that the temperatures used in the method 200 is lower than the melting temperatures of the metals exemplified above, where for example the melting points of Ni 1453 °C, Cu is 1084 °C, Au 1064°C, and Ag 960 °C.

The method may further comprise evacuating 210 the process chamber to a pressure below 10⁻⁵ mbar after the formation of the graphene layer 110.

The method may further comprise a first cooling step, wherein the process chamber is cooled 212 to a temperature in the range of 350 °C to 400 °C thereby cooling the graphene layer 110. The process chamber may alternatively be evacuated 210 to a pressure below 10⁻⁵ mbar during the first cooling step.

The method may further comprise a second cooling step wherein a coolant gas is introduced 213 into the process chamber and the process chamber is cooled 214 to a temperature in the range of 50 °C to 150 °C thereby cooling the graphene layer 110. The coolant gas may, for example, be H₂ or another inert gas.

The pressure in the process chamber may be in the range of 0.2 mbar to 1.0 mbar during the second cooling step. The pressure in the process chamber may for instance be 0.5 mbar during the second cooling step.

The method may finally comprise a third cooling step, wherein the process chamber is evacuated 215, for example, to a pressure below 10⁻⁵ mbar, and the graphene layer 110 is left to cool 216 to room temperature.

The material structure 100 comprising the graphene layer 110 on the metal layer 104 may thereafter be removed from the process chamber of the CVD tool.

The number of cooling steps may be determined by the equipment used form the processing. A usual feature of cooling procedures is that there are two cooling steps. After the graphene layer formation is finished, additional gas input may be suppressed while the process chamber is pumped. On some equipment, the default operation mode leads to high vacuum, when all gases are cut while still pumping, while other equipment let the carrier gas continue to flow. This operation is kept until the temperature is sufficiently low, typically in the range of 350 °C - 400 °C as discussed above, for the machine to consider it safe to switch to other operation modes, allowing the user to vent the system. As a precaution to avoid operator burns and to avoid interactions of graphene with oxygen at 400 °C, the sample may be cool down further in an inert gas.

The skilled person realizes that the value of the pressure in the process chamber is not critical. A higher pressure will for example result in a faster cooling, but the difference in time is generally not large compared to the duration of the whole process.

It may be noted that the method may comprise only one cooling step.

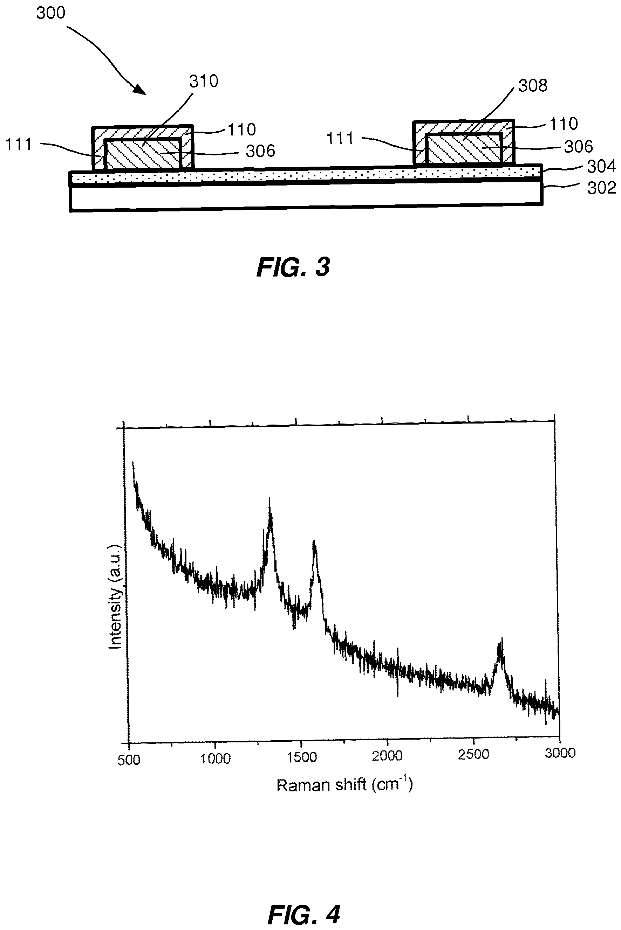

Figure 3 illustrates a material structure 300 similar to the material structure 100 described above. The substrate 302 is exemplified to be undoped. An adhesion layer 304 as described above in relation to the adhesion layer 108 is provided on the substrate 302. A patterned metal layer 306 is further provided on top of the adhesion layer 304. The metal layer 306 may be the same as the metal layer 104 described above. The patterned metal layer 306 may comprise a plurality of separate metal structures as illustrated by the metal structures 308 and 310 arranged on the adhesion layer 304. The skilled person in the art realizes that different lithographic procedures may be used to form the patterned metal layer 306. The patterned metal layer may be formed by optical lithography, electrical beam lithography and/or imprint lithography. As an example, photolithography may be performed on a continuous metal layer such as the metal layer 104 of the material structure 100, discussed above to provide the patterned metal layer 306. Alternatively, lithography processes may be used prior to forming the metal layer 104 together with a lift-off process after the metal formation to provide the patterned metal layer 306.

It may further be noted that the selectivity of the formation of graphene on the metal layer results in that graphene is predominately formed on the metal layer and hence not on regions in between the metal structures 308 and 310 to the same extent. The graphene layer 110 may further be formed on top of the metal structures 308 and 310 of the metal layer 306 and on side walls 111 or facets of the metal structures 308 and 310. The surface area of graphene layer 110 on the metal structures 308 and 310 is thereby increased.

Figure 4 illustrates a Raman spectrum obtained on a graphene layer produced by the method describes above. Raman spectroscopy was performed with an excitation wavelength of 633 nm, at a laser intensity of 8 mW. In more detail, a material structure was provided as discussed above in relation to Figs. 1a, 1b and 3. The material structure used for the spectroscopy comprised a 1000 nm Cu layer formed on a 3 nm tick adhesion layer of Ta; the adhesion layer was arranged on an insulating layer of silicon nitride with a thickness of about 300 nm formed on top of a silicon wafer. The method comprised the step of introducing a H₂ carrier gas into the process chamber of the CVD tool to obtain a pressure of 0.03 mbar and heating the process chamber to a temperature in the range of 800 °C to 900 °C thereby heating the metal layer, more particular to a temperature of 900 °C. This heating step may be referred to as an annealing of the material structure. A graphene layer was formed on the Cu metal layer by introducing a carbon-including deposition-gas in form of methane together with an additional gas in form of H₂ into the process chamber in a 1:1 ratio. The obtained gas of CH₄:H₂ was introduced in the process chamber which was maintained at a pressure of 1 mbar. The deposition of the, by the heating formed, carbon-including precursors was performed for 10 minutes at a temperature of 900 °C to form the graphene layer on the Cu metal layer.

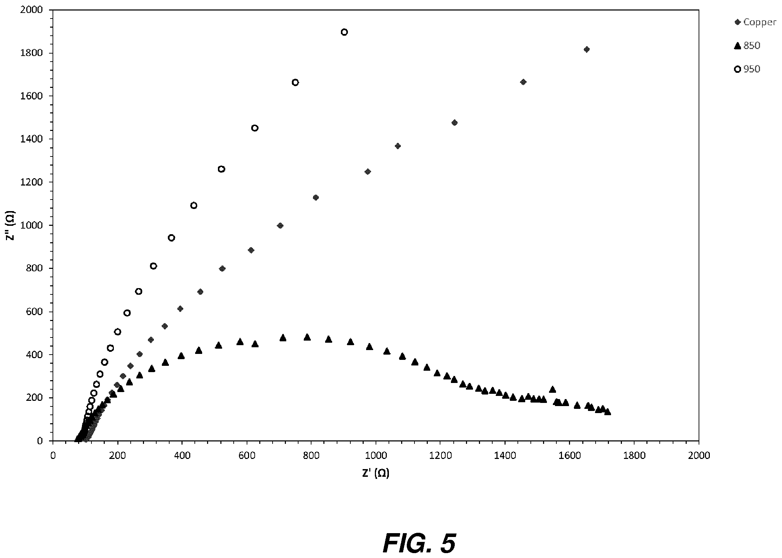

Figure 5 illustrates electrochemical impedance spectroscopy measurements for graphene layers fabricated at different temperatures. The graphene layers were measured with graphene on a metal layer formed by pre-patterned copper electrodes. For the measurement, the electrolyte was phosphate buffer saline 10 mM, pH 7.4 and 5 mM of ferrocyanide [Fe(CN)6]3-/4- electrochemical probe. The excitation was an alternate current of amplitude 5 mV, from 0.1 Hz to 100 kHz in frequency. The impedance measurements show that the graphene layer prepared at 950 °C, curve illustrated by circles, exhibits larger impedance compared to the graphene layer prepared at a lowered temperature of 850 °C, see curve marked by triangles. For reference, figure 5 also shows a reference electrochemical impedance spectroscopy measurement performed on the pre-patterned copper electrodes without a graphene layer, see curve marked with diamonds. From the graph it is to be understood that the graphene layer formed at the temperature of 950 °C exhibits a larger impedance than for the pure copper electrodes. In contrast, the graphene layer prepared at a lowered temperature of 850 °C, see curve marked by triangles, shows lower impedance compared to the reference electrode. Thus, the graphene layer formed by the inventive method offers a lowered impedance allowing for improved sensitivity.

As an example, an electrochemical sensor typically measures an increase of impedance when a target molecule is detected. Electrodes having a low value of impedance therefore allow for increased sensitivity as smaller changes of impedance results in a relatively larger impedance change. It is therefore possible to detect lower concentrations of the target molecules.

The person skilled in the art realizes that the present invention by no means is limited to the preferred embodiments described above. On the contrary, many modifications and variations are possible, within the scope of the appended claims.

For example, the graphene layer may be a single layer of carbon atoms, i.e. be formed by a monolayer graphene. The graphene layer may, however, comprise only a single layer. The graphene layer may, alternatively, be of bilayer or multilayer type, i.e. comprising two or more layers of carbon atoms arranged in honeycomb-like patterns in each layer, as long as conformal, or at least substantially conformal, coverage on the metal layer is achieved. By not requiring the graphene layer to be a monolayer, the fabrication cost and complexity related to the graphene layer may be reduced. The stacking of the individual layers for bilayer graphene may be of e.g. A-A or A-B (Bernal) type. The stacking of the individual layers for multilayer graphene (e.g. trilayer) may be of e.g. A-A-A, A-B-A, i.e. Bernal type, A-B-C, rhombohedral type, or of other stacking types depending on e.g. the number of carbon atom layers in the multilayer graphene.

It may further be note that by not requiring monolayer formation of graphene layer a larger number of metal layers may be used. As mentioned above, nickel is known to lead to many more layers. This property may be attributed to the carbon solubility in the nickel at the process temperatures provided above. Carbon solubility in carbon at the process temperatures is, however, substantially zero or reduced compared to e.g. nickel extremely small in copper leading to a smaller number of multilayers and a more uniform graphene layer.

To this end, for particular applications, a smaller or larger amounts of multilayers can provide better results, and this could also be controlled by the choice of the metal layer. In electrochemical sensors, for example, the existence of multilayers, and possibly the stacking of the layers may play a role in the electron transfer from the metal layer into an aqueous solution through the graphene layer, so different base metals might provide different results.

The ability to choose the base metal can have advantages for the applications. For example, less expensive applications with disposable electrodes could use copper, while more expensive applications that would benefit from reusing the electrodes could require the use of noble metals such as gold.

It may further be noted that while the number of graphene layers on copper is mainly guided by the process time, in the case of nickel the number of layers also depends on the cooling conditions, requiring additional controls on the cooling speed to obtain the desired result.

The metal layer may form a substrate.

The metal layer may be formed by a metal film.

The metal layer may be a metal film such as a metal foil. The metal foil may for example be a Cu foil. The metal layer may be a metal plate.

The method may comprise introducing a further gas during the graphene formation, the further gas being different to the additional gas. Elements of the further gas may be adsorbed on and/or absorbed by the graphene layer such that the physical properties of the graphene layer, in particular to facilitate biofunctionalization. As examples, ammonia or nitrogen may be used to provide hetero-atom doping of graphene during growth. The method may thereby take advantage of gas dilation during use to tune crystalline size and crystalline fraction of graphene. As an example, hydrogen or/and argon dilution of methane allows for the control of the crystalline size and crystalline fraction of graphene.

Additionally, variations to the disclosed embodiments can be understood and effected by the skilled person in practicing the claimed invention, from a study of the drawings, the disclosure, and the appended claims.

## Claims

1. Method for formation of a graphene layer (110) on a metal layer (104, 306) arranged in a process chamber of a chemical vapour deposition, CVD, tool, the method (200) comprising:
heating (204) the process chamber to a temperature in the range of 800 °C to 900 °C thereby heating the metal layer (104, 306),
introducing (206) a carbon-including deposition-gas into the process chamber thereby forming carbon-including precursors,
transporting (208) the carbon-including precursors to the metal layer (104, 306) thereby forming the graphene layer (110) on the metal layer (104, 306).

2. The method according to claim 1, wherein the metal layer (104, 306) comprises a metal chosen from the group consisting of: Cu, Ni, Co, Mo, Ru, Pd, Ir, Pt, Au, Ag, Fe and stainless steel.

3. The method according to claim 1, wherein the metal layer (104, 306) consists of a metal chosen from the group consisting of: Cu, Ni, Co, Mo, Ru, Pd, Ir, Pt, Au, Ag, Fe and stainless steel.

4. The method according to any one of claims 1 - 3, wherein the metal layer (104, 306) is arranged on a substrate (102, 302).

5. The method according to claim 4, wherein the metal layer (104, 306) is arranged on an adhesion layer (108, 304) arranged on the substrate (102, 302).

6. The method according to claim 4, wherein the substrate (102) is provided with an insulating layer (106) and wherein the metal layer (104) is formed on the insulating layer (106).

7. The method according to claim 5, wherein the substrate (102) is provided with an insulating layer (106) and wherein the adhesion layer (108) is formed on the insulating layer (106).

8. The method according to any one of the claims 1 - 7, wherein a pressure in the process chamber during the formation of the graphene layer (110) lies within a range of 0.2 mbar to 1.5 mbar.

9. The method according to any one of the claims 1 - 8, wherein the carbon-including deposition-gas consists of a gas chosen from the group consisting of: methane, ethene and ethyne.

10. The method according to any one of the claims 1 - 9, wherein the method (200) further comprises: introducing an additional gas into the process chamber.

11. The method according to claim 10, wherein the additional gas comprises a gas chosen from the group consisting of: H₂, Ar, NH₃, and N₂.

12. The method according to any one of the claims 1 - 11, wherein the method further comprises: a first cooling step, wherein the process chamber is cooled to a temperature in the range of 350 °C to 400 °C thereby cooling (212) the graphene layer (110).

13. The method according to claim 12, wherein the process chamber is evacuated (210) to a pressure below 10⁻⁵ mbar prior to or during the first cooling step.

14. The method according to claim 12 or 13, wherein the method (200) further comprises: a second cooling step wherein a coolant gas is introduced (213) into the process chamber and the process chamber is cooled to a temperature in the range of 50 °C to 150 °C thereby cooling (214) the graphene layer (110).

15. The method according to claim 13, wherein the pressure in the process chamber is about 0.2 mbar to 1.0 mbar during the second cooling step.
